# EUROPEAN PATENT APPLICATION

(11) **EP 4 468 376 A1**
(43) Date of publication of application: **27.11.2024**
(21) Application number: 24169421.5
(22) Date of filing: 10.04.2024
(51) Int. Cl.: H01L 33/40

(54) **SEMICONDUCTOR LIGHT EMITTING DEVICE FOR PIXEL AND METHOD FOR MANUFACTURING THE SAME**

(30) Priority: 23.05.2023 KR 20230066138
(71) Applicant: LG Electronics Inc., Yeongdeungpo-gu Seoul 07336 (KR)
(72) Inventor: JEON, Jina, 06772 Seoul (KR); YU, Hyosang, 06772 Seoul (KR); PARK, Hyungjo, 06772 Seoul (KR); KANG, Donghun, 06772 Seoul (KR); SEONG, Junseok, 06772 Seoul (KR); BONG, Hajong, 06772 Seoul (KR)
(74) Representative: Vossius & Partner Patentanwälte Rechtsanwälte mbB

(57) **Abstract**

A semiconductor light emitting device including a light emitting structure and a reflective contact layer disposed below the light emitting structure. Further, the reflective contact layer includes a plurality of ohmic contact areas contacting a first conductivity-type semiconductor layer of the light emitting structure in which a first ohmic contact area has a different size than a second ohmic contact area included in the plurality of ohmic contact areas; and a first reflective layer comprising an AgAu alloy and covering the plurality of ohmic contact areas.

## Description

### BACKGROUND OF THE DISCLOSURE

### 1. Field of the Disclosure

An embodiment relates to a semiconductor light emitting device for a pixel and a manufacturing method thereof.

### 2. Background of the Related Art

Large-area displays include liquid crystal displays (LCDs), OLED displays or Micro-LED displays. In more detail, a micro-LED display uses micro-LED, which is a semiconductor light emitting device having a diameter or cross-sectional area of 100µm or less, as a display device.

A micro-LED display has excellent performance in many characteristics such as contrast ratio, response speed, color reproduction rate, viewing angle, brightness, resolution, lifespan, luminous efficiency and luminance because it uses a micro-LED, which is a semiconductor light emitting device, as a display device. In particular, micro-LED displays can separate and combine screens in a modular manner. Thus, the micro-LED display has the advantage of freely adjusting the size or resolution and the advantage of being able to implement a flexible display.

However, there is a technical problem in that it is difficult to quickly and accurately transfer the semiconductor light emitting device to the display panel because more than millions of semiconductor light emitting devices are required for a large micro-LED display. Transfer technologies that have been recently developed include a pick and place process, a laser lift-off method, or a self-assembly method. Among these, the self-assembly method includes a semiconductor light emitting device finding an assembly position in a fluid by itself, and is an advantageous method for implementing a large-screen display device.

Recently, although a micro-LED structure suitable for self-assembly has been proposed in US Patent No. 9,825,202, etc., research on a technology for manufacturing a display through self-assembly of micro-LEDs is still insufficient. In particular, for quickly transferring millions or more semiconductor light emitting devices to a large display in the related art, although the transfer speed can be improved, there is a technical problem in that the transfer error rate is increased and the transfer yield is lowered.

In related technologies, a self-assembly type transfer process using dielectrophoresis (DEP) has been attempted. However, there is a problem in that the self-assembly rate is low due to the non-uniformity of the DEP force.

On the other hand, the self-assembly method using DEP force of internal technology includes firstly moving the LED chip to the assembly hole area by magnetic force of the magnet, and assembling the LED chip in the assembly hole with DEP force by applying an alternating current to the assembly line. Because the upper and lower sides of the LED chip are composed of an n-type semiconductor layer and a p-type semiconductor layer, and an n-type electrode and a p-type electrode respectively disposed, it is preferable to assemble the LED chip into the assembly hole while maintaining the vertical direction. This is because electrical disconnection defects can occur in a subsequent wiring process when the LED chip is assembled with the direction tilted or reversed by 180 degrees.

However, according to an internal study, it has been studied as a difficult problem to directionally control an LED chip during self-assembly moving in a fluid, and a solution to this problem is required. In addition, in the related art, there is a problem in that the lighting rate is lowered due to a decrease in electrical contact characteristics between the electrodes of the selfassembled LED chip and the panel electrodes.

In addition, for a semiconductor light emitting device emitting red color, there is a problem in that light emitting efficiency is lowered because the side surface does not emit light, and the luminance is lowered due to severe leakage of carriers at an initial low current due to fast mobility.

### SUMMARY OF THE DISCLOSURE

One object of the disclosure is to improve light efficiency of a semiconductor light emitting device for a pixel. Another object is to improve the regular assembly rate in the self-assembly method.

In addition, still another object is to form a reflective layer without increasing process difficulty and increasing the thickness of the semiconductor light emitting device. In addition, providing a semiconductor light emitting device for a pixel capable of securing reflectivity for each wavelength band of RGB color is another object.

To achieve these and other objects, the present disclosure provides a semiconductor light emitting device for a pixel including a light emitting structure having a first conductivity-type semiconductor layer, an active layer disposed on the first conductivity-type semiconductor layer and a second conductivity-type semiconductor layer disposed on the active layer, and a reflective contact layer disposed below the light emitting structure. Also, the reflective contact layer can include a first reflective layer including an AgAu alloy.

In addition, in an embodiment, the reflective contact layer can further include an ohmic contact area contacting a lower surface of the first conductivity-type semiconductor layer. A lower surface of the ohmic contact area can also be closer to the first conductivity-type semiconductor layer than a lower surface of the first reflective layer.

Further, the ohmic contact area can include at least one of AuGe, Ge, Ti, Pd, Ni, and IZO. In addition, in an embodiment, the ohmic contact area can be randomly distributed in an irregular size within the reflective contact layer. A lower surface of the first conductivity-type semiconductor layer can include a first region in contact with the ohmic contact area and a second region in contact with the first reflective layer. In addition, the first region can be 5% or more of the area of the lower surface of the first conductivity-type semiconductor layer.

Further, the first reflection layer can have different reflectivity for each wavelength band of RGB color according to the composition of the AgAu alloy.

In another aspect, the present disclosure provides a method of manufacturing a semiconductor light emitting device for a pixel according including forming a light emitting structure including a first conductivity-type semiconductor layer, an active layer, and a second conductivity-type semiconductor layer; forming a first metal layer containing AuGe on the light emitting structure; forming a second metal layer containing Ag on the first metal layer; forming a third metal layer containing Au on the second metal layer; and heat-treating the first, second, and third metal layers.

In addition, by the step of heat treating the first, second, and third metal layers, Ge of the first metal layer diffuses into the inside to form a plurality of ohmic contact areas in contact with the first conductivity-type semiconductor layer, Ag of the second metal layer and Au of the first and third metal layers can form an AgAu alloy to form the first reflective layer. Also, the plurality of ohmic contact areas are randomly distributed and can contact 5% or more of the area of the first conductivity-type semiconductor layer.

### ADVANTAGEOUS EFFECTS OF THE DISCLOSURE

The semiconductor light emitting device for a pixel according to the embodiment has a reflective layer provided under the chip, so that light efficiency is improved. For example, because the reflective layer is formed to include an AgAu alloy, the reflective layer is not damaged in the self-assembly method, and the ohmic contact layer can be manufactured thinly to improve light efficiency.

In addition, the embodiment has a technical effect of improving the regular assembly rate in the self-assembly method. For example, the embodiment includes a reflective layer containing an AgAu alloy, so that during self-assembly in a fluid, the metal is not oxidized or peeled off, so the metal material does not interfere with assembly, and there is a technical effect that can improve the assembly rate.

The embodiment has a technical effect of securing high reflectivity for each wavelength band of RGB color. For example, by controlling the composition of the AgAu alloy included in the reflective layer of the embodiment, it is possible to have a high reflectivity with respect to each wavelength band of RGB colors.

In addition, the embodiment can improve light efficiency without increasing the thickness of the semiconductor light emitting device or increasing the difficulty of the process. For example, because the embodiment includes a reflective layer including an AgAu alloy, light efficiency of a semiconductor light emitting device can be improved with a thinner thickness and lower process difficulty than reflective layers such as DBR and ODR. In addition, according to the embodiment, the ohmic contact area can be protected from the reflective layer, so that electrical reliability can be improved.

Further scope of applicability of the present invention will become apparent from the detailed description given hereinafter. However, the detailed description and specific examples, while indicating preferred embodiments of the invention, are given by illustration only, since various changes and modifications within the spirit and scope of the invention will become apparent to those skilled in the art from this detailed description.

### BRIEF DESCRIPTION OF THE DRAWINGS

The present invention will become more fully understood from the detailed description given hereinbelow and the accompanying drawings, which are given by illustration only, and thus are not limitative of the present invention, and wherein:
FIG. 1 is an exemplary view of a living room of a house in which a display device according to an embodiment is disposed.
FIG. 2 is a block diagram schematically illustrating a display device according to an exemplary embodiment.
FIG. 3 is a circuit diagram showing an example of a pixel of FIG. 2.
FIG. 4 is an enlarged view of a first panel area in the display device of FIG. 1.
FIG. 5 is a cross-sectional view along line B1-B2 of region A2 of FIG. 4.
FIG. 6 is an exemplary view in which a light emitting device according to an embodiment is assembled to a substrate by a self-assembly method.
FIGS. 7A and 7B are cross-sectional views of a semiconductor light emitting device studied internally.
FIG. 8 is a cross-sectional view of a semiconductor light emitting device for a pixel according to the first embodiment.
FIG. 9 is a cross-sectional view of a semiconductor light emitting device for a pixel according to a second embodiment.
FIG. 10 is reflectivity data of a reflective layer to which an embodiment is applied.

### DETAILED DESCRIPTION OF THE DISCLOSURE

Hereinafter, embodiments disclosed in the present description will be described in detail with reference to the accompanying drawings. The suffixes 'module' and 'part' for components used in the following description are given or mixed in consideration of ease of specification, and do not have a meaning or role distinct from each other by themselves. In addition, the accompanying drawings are provided for easy understanding of the embodiments disclosed in the present specification, and the technical ideas disclosed in the present specification are not limited by the accompanying drawings. In addition, when an element, such as a layer, area, or substrate, is referred to as being 'on' another component, this includes that it is directly on the other element or there can be other intermediate elements in between.

The display device described in this specification includes a digital TV, a mobile phone, a smart phone, a laptop computer, a digital broadcasting terminal, a personal digital assistant (PDA), a portable multimedia player (PMP), a navigation, a Slate PC, a Tablet PC, an Ultra-Book, a desktop computer, and the like. However, the configuration according to the embodiment described in this specification can be applied to a device capable of displaying even a new product type to be developed in the future. Hereinafter, a semiconductor light emitting device according to an embodiment and a display device including the same will be described.

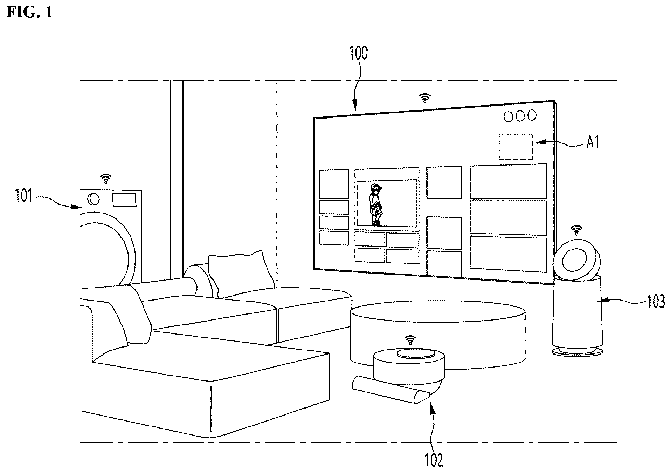

FIG. 1 shows a living room of a house in which a display device 100 according to an embodiment is disposed. The display device 100 can display the status of various electronic products such as the washing machine 101, the robot cleaner 102, and the air purifier 103, and communicate with each electronic product based on IoT (Internet of Things), and can control each electronic product based on the user's setting data.

The display device 100 can also include a flexible display manufactured on a thin and flexible substrate. The flexible display can be bent or rolled like paper while maintaining the characteristics of a conventional flat panel display. In the flexible display, visual information can be implemented by independently controlling light emission of unit pixels arranged in a matrix form. A unit pixel means a minimum unit for realizing one color. Further, a unit pixel of the flexible display can be implemented by a light emitting device. For example, the light emitting device can be a Micro-LED or a Nano-LED, but is not limited thereto.

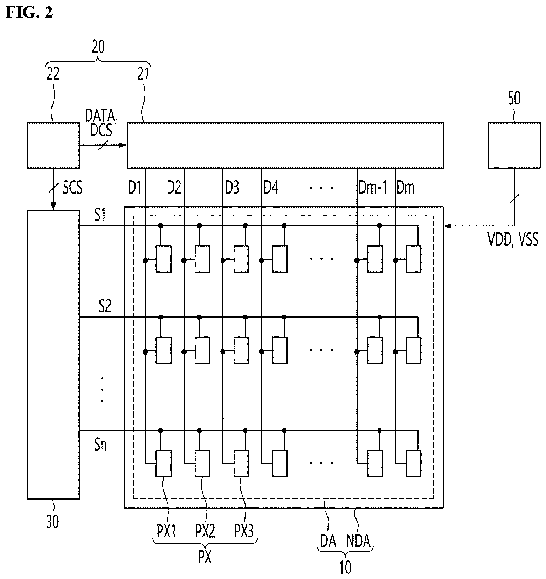

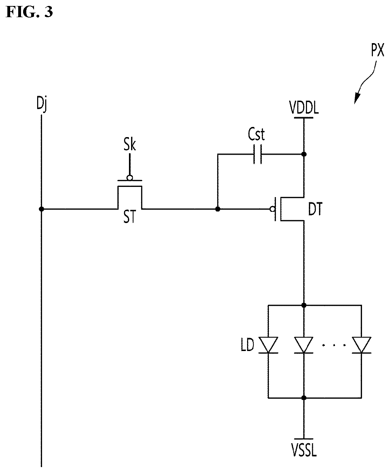

Next, FIG. 2 is a block diagram schematically showing a display device according to an embodiment, and FIG. 3 is a circuit diagram showing an example of the pixel of FIG. 2. Referring to FIGS. 2 and 3, the display device includes a display panel 10, a driving circuit 20, a scan driving unit 30, and a power supply circuit 50. The display device 100 also drives the light emitting device using an active matrix (AM) method or a passive matrix (PM, passive matrix) method.

In addition, the driving circuit 20 can include a data driving unit 21 and a timing control unit 22. Also, as shown, the display panel 10 can be divided into a display area DA and a non-display area NDA disposed around the display area DA. In particular, the display area DA is an area in which pixels PX are formed to display an image. The display panel 10 also includes data lines (D1 to Dm, m is an integer greater than or equal to 2), scan lines crossing the data lines D1 to Dm (S 1 to Sn, n is an integer greater than or equal to 2), the high-potential voltage line supplied with the high-voltage, the low-potential voltage line supplied with the low-potential voltage, and the pixels PX connected to the data lines D1 to Dm and the scan lines S1 to Sn can be included.

As shown in FIG. 1, each pixel PX can include a first sub-pixel PX1, a second sub-pixel PX2, and a third sub-pixel PX3. In particular, the first sub-pixel PX1 emits a first color light of a first wavelength, the second sub-pixel PX2 emits a second color light of a second wavelength, and the third sub-pixel PX3 emits a third color light of a wavelength can be emitted. For example, the first color light can be red light, the second color light can be green light, and the third color light can be blue light, but is not limited thereto. In addition, FIG. 1 illustrates each pixel PX includes three sub-pixels in FIG. 2, but the present disclosure is not limited thereto. That is, each pixel PX can include four or more sub-pixels.

Each of the first sub-pixel PX1, the second sub-pixel PX2, and the third sub-pixel PX3 is connected to at least one of the data lines D 1 to Dm, and at least one of the scan lines S 1 to Sn, and a high potential voltage line. As shown in FIG. 3, the first sub-pixel PX1 can include the light emitting devices LD, plurality of transistors for supplying current to the light emitting devices LD, and at least one capacitor Cst.

Also, each of the first sub-pixel PX1, the second sub-pixel PX2, and the third sub-pixel PX3 can include only one light emitting device LD and at least one capacitor Cst. Each of the light emitting devices LD can be a semiconductor light emitting diode including a first electrode, a plurality of conductivity-type semiconductor layers, and a second electrode. Here, the first electrode can be an anode electrode and the second electrode can be a cathode electrode, but the present invention is not limited thereto.

Referring to FIG. 3, the plurality of transistors include a driving transistor DT for supplying current to the light emitting devices LD, and a scan transistor ST for supplying a data voltage to the gate electrode of the driving transistor DT. As shown, the driving transistor DT includes a gate electrode connected to the source electrode of the scan transistor ST, a source electrode connected to a high potential voltage line to which a high potential voltage is applied, and a drain electrode connected to first electrodes of the light emitting devices LD. Further, the scan transistor ST includes a gate electrode connected to the scan line Sk, where k is an integer satisfying 1≤k≤n, a source electrode connected to the gate electrode of the driving transistor DT, and a drain electrode connected to data lines Dj, where j is integer satisfying 1≤j≤m.

Further, capacitor Cst is formed between the gate electrode and the source electrode of the driving transistor DT, and the storage capacitor Cst can charge a difference between the gate voltage and the source voltage of the driving transistor DT. The driving transistor DT and the scan transistor ST can also be formed of a thin film transistor. In addition, although the driving transistor DT and the scan transistor ST have been mainly described in FIG. 3 as being formed of a P-type MOSFET (Metal Oxide Semiconductor Field Effect Transistor), the present disclosure is not limited thereto. For example, driving transistor DT and the scan transistor ST can be formed of an N-type MOSFET. In this instance, the positions of the source electrode and the drain electrode of each of the driving transistor DT and the scan transistor ST can be changed.

In addition, in FIG. 3 illustrates each of the first sub-pixel PX1, the second sub-pixel PX2, and the third sub-pixel PX3 includes one driving transistor DT, one scan transistor ST, and 2T1C (2 Transistor - 1 capacitor) having a capacitor Cst, but the present disclosure is not limited thereto. Each of the first sub-pixel PX1, the second sub-pixel PX2, and the third sub-pixel PX3 can include a plurality of scan transistors ST and a plurality of capacitors Cst.

Referring back to FIG. 2, the driving circuit 20 outputs signals and voltages for driving the display panel 10. As shown, the driving circuit 20 can include a data driver 21 and a timing controller 22. In more detail, the data driver 21 receives digital video data DATA and a source control signal DCS from the timing controller 22. The data driver 21 also converts the digital video data DATA into analog data voltages according to the source control signal DCS and supplies converted data voltages to the data lines D1 to Dm of the display panel 10.

Further, the timing controller 22 receives digital video data DATA and timing signals from the host system. In particular, timing signals can include a vertical sync signal, a horizontal sync signal, a data enable signal, and a dot clock. The host system can be an application processor of a smartphone or tablet PC, a monitor, or a system-on-chip of a TV. In addition, the scan driver 30 receives the scan control signal SCS from the timing controller 22. The scan driver 30 also generates scan signals according to the scan control signal SCS and supplies the signals to the scan lines S1 to Sn of the display panel 10. The scan driver 30 can include a plurality of transistors and can be formed in the non-display area NDA of the display panel 10. In addition, the scan driver 30 can be formed of an integrated circuit, and in this case, can be mounted on a gate flexible film attached to the other side of the display panel 10.

Further, the power supply circuit 50 generates a high potential voltage VDD and a low potential voltage VSS for driving the light emitting devices LD of the display panel 10 from the main power source, and the power supply circuit can supply VDD and VSS to the high-potential voltage line and the low-potential voltage line of the display panel 10. In addition, the power supply circuit 50 can generate and supply driving voltages for driving the driving circuit 20 and the scan driving unit 30 from the main power.

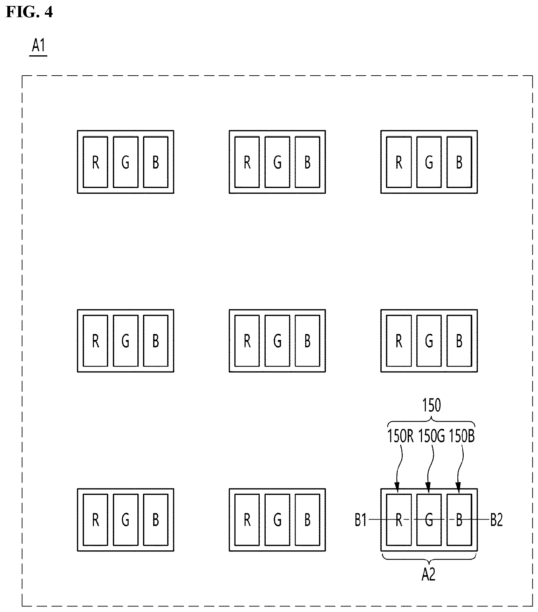

Next, FIG. 4 is an enlarged view of the first panel area A1 in the display device of FIG. 1. Referring to FIG. 4, the display device 100 according to the embodiment can be manufactured by mechanically and electrically connecting a plurality of panel areas such as the first panel area A1 by tiling.

In more detail, the first panel area A1 can include a plurality of light emitting devices 150 arranged for each unit pixel (PX in FIG. 2). For example, the unit pixel PX can include a first sub-pixel PX1, a second sub-pixel PX2, and a third sub-pixel PX3. A plurality of red-light emitting devices 150R are also disposed in the first sub-pixel PX1, a plurality of green light emitting devices 150G are disposed in the second sub-pixel PX2, and a plurality of blue light emitting devices 150B are disposed in the third sub-pixel PX3. The unit pixel PX can further include a fourth sub-pixel in which a light emitting device is not disposed, but is not limited thereto. In addition, the light emitting device 150 can be the semiconductor light emitting device.

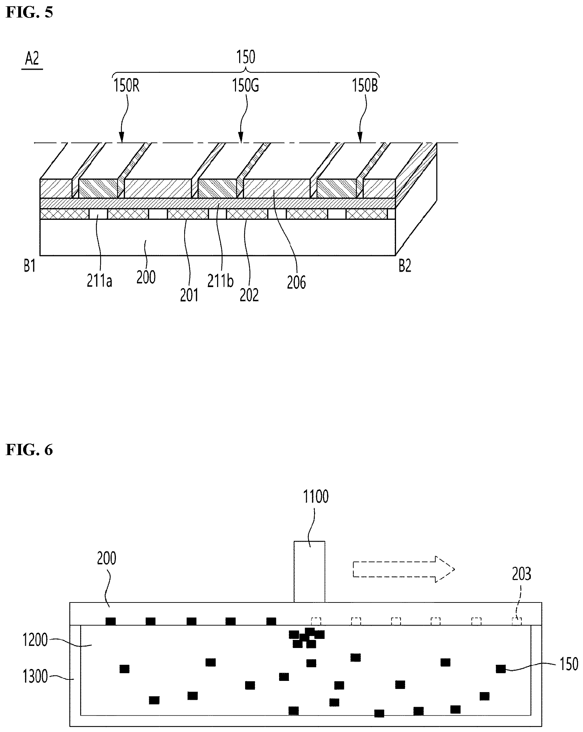

Next, FIG. 5 is a cross-sectional view taken along line B1-B2 of area A2 of FIG. 4. Referring to FIG. 5, the display device 100 of the embodiment can include a substrate 200, assembled wiring lines 201 and 202, a first insulating layer 211a, a second insulating layer 211b, a third insulating layer 206, and a plurality of light emitting devices 150.

As shown, the assembly line can include a first assembly line 201 and a second assembly line 202 spaced apart from each other. In more detail, the first assembly wire 201 and the second assembly wire 202 can be provided to generate dielectrophoretic force for assembling the light emitting device 150. In addition, the first assembly line 201 and the second assembly line 202 can be electrically connected to the electrode of the light emitting device to function as electrodes of a display panel.

Also, the assembly wires 201 and 202 can be formed of light-transmitting electrodes (ITO) or can include a metal material having excellent electrical conductivity. For example, the assembly wires 201 and 202 can be formed of at least one of titanium (Ti), chromium (Cr), nickel (Ni), aluminum (Al), platinum (Pt), gold (Au), tungsten (W) or molybdenum (Mo) or an alloy thereof.

In addition, a first insulating layer 211a can be disposed between the first assembly line 201 and the second assembly line 202, a second insulating layer 211b can be disposed on the first assembly line 201 and the second assembly line 202. The first insulating layer 211a and the second insulating layer 211b can be an oxide film or a nitride film, but are not limited thereto. Also, the light emitting device 150 can include a red-light emitting device 150R, a green light emitting device 150G, and a blue light emitting device 150B to form a sub-pixel, but is not limited thereto, and the light emitting device can implement red and green colors by including a red phosphor and a green phosphor, respectively.

Further, the substrate 200 can be formed of glass or polyimide. In addition, the substrate 200 can include a flexible material such as polyethylene naphthalate (PEN) or polyethylene terephthalate (PET). Also, the substrate 200 can be a light-transmitting material, but is not limited thereto. The third insulating layer 206 can include an insulating and flexible material such as polyimide, PEN, PET, or the like, and can be integrally formed with the substrate 200 to form a single substrate.

In addition, the third insulating layer 206 can be a conductive adhesive layer having adhesiveness and conductivity, and the conductive adhesive layer can be flexible to enable a flexible function of the display device. For example, the third insulating layer 206 can be an anisotropy conductive film (ACF) or a conductive adhesive layer such as an anisotropic conductive medium or a solution containing conductive particles. The conductive adhesive layer can also be a layer example electrically conductive in a direction perpendicular to the thickness but electrically insulating in a direction horizontal to the thickness.

Further, the third insulating layer 206 can include an assembly hole 203 into which the light emitting device 150 is inserted (refer to FIG. 6). Accordingly, during self-assembling, the light emitting device 150 can be easily inserted into the assembly hole 203 of the third insulating layer 206. Also, the assembly hole 203 can be called an insertion hole, a fixing hole, an alignment hole, or the like. The distance between the assembly wires 201 and 202 is smaller than the width of the light emitting device 150 and the width of the assembly hole 203, so that the assembly position of the light emitting device 150 using an electric field can be fixed more precisely.

In addition, a third insulating layer 206 is formed on the assembly wirings 201 and 202 to protect the 201 and 202 from the fluid 1200, and the third insulating layer 206 can prevent leakage of current flowing through the two wirings 201 and 202. The third insulating layer 206 can be formed of a single layer or multiple layers of an inorganic insulator such as silica or alumina or an organic insulator. In addition, the third insulating layer 206 can include an insulating and flexible material such as polyimide, PEN, PET, etc., and can be formed integrally with the substrate 200 to form a single substrate.

The third insulating layer 206 can be an adhesive insulating layer or a conductive adhesive layer having conductivity. Also, the third insulating layer 206 is ductile and can enable a flexible function of the display device. The third insulating layer 206 has a barrier wall, and an assembly hole 203 can be formed by the barrier wall. For example, when the substrate 200 is formed, by removing a portion of the third insulating layer 206, each of the light emitting devices 150 can be assembled into the assembly hole 203 of the third insulating layer 206.

Also, an assembly hole 203 to which the light emitting devices 150 are coupled is formed in the substrate 200, and a surface on which the assembly hole 203 is formed can contact the fluid 1200. The assembly hole 203 can guide an accurate assembly position of the light emitting device 150. In addition, the assembly hole 203 can have a shape and size corresponding to the shape of the light emitting device 150 to be assembled at the corresponding position. Accordingly, it is possible to prevent assembly of another light emitting device or a plurality of light emitting devices into the assembly hole 203.

Next, FIG. 6 is a view showing an example in which a light emitting device according to an embodiment is assembled to a substrate by a self-assembly method, and the self-assembly method of the light emitting device will be described with reference to the drawings. The substrate 200 can be a panel substrate of a display device. In the following description, the substrate 200 will be described as a panel substrate of a display device, but the embodiment is not limited thereto. Referring to FIG. 6, a plurality of light emitting devices 150 can be put into a chamber 1300 filled with a fluid 1200. The fluid 1200 can be water, such as ultrapure water, but is not limited thereto. A chamber can also be called a water bath, container, vessel, or the like.

After this, the substrate 200 is disposed on the chamber 1300. Depending on the embodiment, the substrate 200 can be introduced into the chamber 1300. As shown in FIG. 5, a pair of assembly wires 201 and 202 corresponding to each of the light emitting devices 150 to be assembled can be disposed on the substrate 200. Referring to FIG. 6, after the substrate 200 is disposed, an assembly device 1100 including a magnetic material can move along the substrate 200. As the magnetic material, for example, a magnet or an electromagnet can be used. The assembly device 1100 can move while in contact with the substrate 200 in order to maximize the area of the magnetic field into the fluid 1200. Depending on the embodiment, the assembly device 1100 can include a plurality of magnetic bodies or can include a magnetic body having a size corresponding to that of the substrate 200. In this instance, the moving distance of the assembling device 1100 can be limited within a predetermined range.

Due to the magnetic field generated by the assembly device 1100, the light emitting device 150 in the chamber 1300 can move toward the assembly device 1100. While moving toward the assembly device 1100, the light emitting device 150 can enter the assembly hole 203 by a dielectrophoretic force (DEP force) and come into contact with the substrate 200. Specifically, the assembly wires 201 and 202 form an electric field by an externally supplied power, and dielectrophoretic force can be formed between the assembly wires 201 and 202 by the electric field. The light emitting device 150 can be fixed to the assembly hole 203 on the substrate 200 by this dielectrophoretic force.

By the electric field applied by the assembly wires 201 and 202 formed on the substrate 200, the light emitting device 150 in contact with the substrate 200 can be prevented from being separated by the movement of the assembly device 1100. According to the examples, since the time required for assembling each of the light emitting devices 150 to the substrate 200 can be drastically reduced by the self-assembly method using the above-described electromagnetic field, a large-area high-pixel display can be implemented more quickly and economically.

Also, a predetermined solder layer can be formed between the assembly electrode and the light emitting device 150 assembled on the assembly hole 203 of the substrate 200 to improve the bonding strength of the light emitting device 150. Next, a molding layer can be formed in the assembly hole 203 of the substrate 200. The molding layer can be a light-transmissive resin or a resin containing a reflective material or a scattering material.

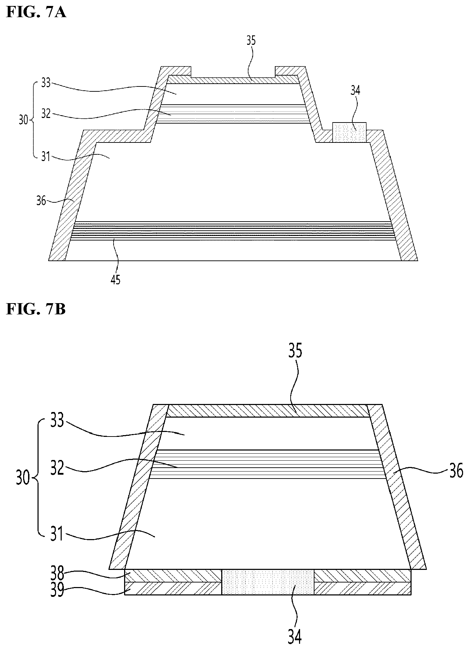

Next, FIGS. 7A and 7B are a cross-sectional view of a semiconductor light emitting device internally researched. In the internal technology, a reflective layer is formed on a bottom to improve the luminance of the semiconductor light emitting device, and the light is reflected toward the top of the semiconductor light emitting device. The reflective layer may be, for example, a DBR layer, omni-directional reflectors, Ag, or the like.

Referring to FIG. 7A, the semiconductor light emitting device can include a light emitting structure 30, a first electrode 34, and a second electrode 35. A DBR layer 45 can be formed under the light emitting structure 30 and can be reflective. The DBR layer 45 can be formed by alternately arranging metal layers or insulating layers having different refractive indices, and improves light efficiency by reflecting light exiting from the bottom to the top.

Referring to FIG. 7B, a semiconductor light emitting device can include a light emitting structure 30, a second electrode 35 disposed on the light emitting structure 30, a first electrode 34 disposed under the light emitting structure 30, an insulating layer 38 and a reflective layer 39 disposed to surround the first electrode 34. The reflective layer 39 can be omni-directional reflectors. Light passing through the bottom of the semiconductor light emitting device is reflected upward through the reflective layer 39, thereby improving light efficiency.

However, in a semiconductor light emitting device using internal technology, when forming a DBR layer at the bottom, it takes a long time to form the semiconductor epi layer. Additionally, as the thickness of the chip increases, aspect ratio needs to be considered when manufacturing ultra-small chips such as micro-LEDs, and there is a problem in that the thickness of the display panel increases. In addition, when the semiconductor light emitting device is selfassembled on a panel substrate, the assembly directionality can be reduced due to the aspect ratio issue between the width and thickness of the miniaturized chip, which can cause a problem in that the assembly rate is reduced.

In addition, when the reflective layer is formed with an omnidirectional reflector (ODR) layer, the ohmic of the N-type semiconductor layer is formed and the reflective layer using an insulating layer and a metal is required, which increases the difficulty of the process and increases the process time. In addition, as the size of the micro-LED is gradually reduced, a semiconductor light emitting device having a vertical structure is required. However, in the vertical structure, it is difficult to apply a reflective film process such as DBR or ODR. Hereinafter, technical features of an embodiment to solve the above problem will be described.

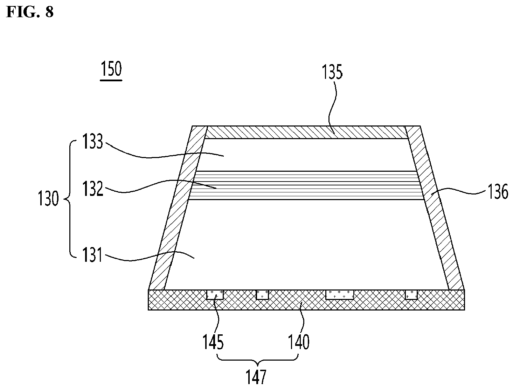

FIG. 8 is a cross-sectional view of a semiconductor light emitting device according to an embodiment. Referring to FIG. 8, the semiconductor light emitting device 150 of the embodiment can be a vertical semiconductor light emitting device. In addition, the semiconductor light emitting device 150 can include a light emitting structure 130, a first electrode 135, a reflective contact layer 147, and a passivation layer 136. The semiconductor light emitting device 150 can be a semiconductor light emitting device emitting red color, but is not limited thereto.

The light emitting structure 130 can include a first conductivity-type semiconductor layer 131, an active layer 132 disposed on the first conductivity-type semiconductor layer 131, and a second conductivity-type semiconductor layer 133 disposed on the active layer 132. The first conductivity-type semiconductor layer 131 can be an n-type semiconductor layer, and the second conductivity-type semiconductor layer 133 can be a p-type semiconductor layer, but is not limited thereto. The first conductivity-type semiconductor layer 131, the active layer 132, and the second conductivity-type semiconductor layer 133 can be made of a compound semiconductor material. For example, the compound semiconductor material can be a Group III-V compound semiconductor material, a Group II-VI compound material, or the like. For example, the compound semiconductor can be selected from the group including a binary compound selected from the group including GaP, GaAs, GaSb, AlP, AlAs, AlSb, InP, InAs, InSb and mixtures thereof, a ternary compound selected from the group including GaNP, GaNAs, GaNSb, GaPAs, GaPSb, AlInP, AlNP, AlNAs, AlNSb, AlPAs, AlPSb, InNP, InNAs, InNSb, InPAs, InPSb, GaAlNP and mixtures thereof and a quaternary compound selected from the group including AlGaInP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof.

For example, the first conductivity-type semiconductor layer 131 can include a first conductivity-type dopant, and the second conductivity-type semiconductor layer 133 can include a second conductivity-type dopant. For example, the first conductivity-type dopant can be an n-type dopant such as silicon (Si), and the second conductivity-type dopant can be a p-type dopant such as boron (B).

The active layer 132 is a region for generating light, and can generate light having a specific wavelength band according to material properties of the compound semiconductor. In addition, the active layer can have a multi-quantum well structure or a single quantum well structure, and a wavelength band can be determined by an energy band gap of a compound semiconductor included in the active layer. Accordingly, the semiconductor light emitting device of the embodiment can generate UV light, blue light, green light, and red light according to the energy band gap of the compound semiconductor included in the active layer.

In addition, a second electrode 135 disposed on the light emitting structure 130 can be included. The second electrode 135 can include a transparent conductive material such as ITO, ZnO, GZO, or IGZO, and can transmit an electrical signal from a wiring for driving a semiconductor light emitting device to the second conductivity-type semiconductor layer 133.

Also, a passivation layer 136 can be disposed to surround the light emitting structure 130. As shown in FIG. 8, a reflective layer 140 can be disposed below the light emitting structure 130. AuGe was mainly used as a material for ohmic contact of the first conductivity-type semiconductor layer in a semiconductor light emitting device that is being studied internally. However, because AuGe has a high surface roughness and is thick, it is difficult for light generated in the active layer to be reflected upward even when a reflective layer is additionally attached. In addition, Ge has a high absorption power in the red color wavelength region, so there is a problem in that light efficiency is reduced.

In addition, the ohmic layer and the reflective layer for ohmic contact of the semiconductor layer are divided into different regions and formed as a point contact, etc., but as chips are miniaturized, such as micro-LEDs, there is a problem in that it is difficult to separately form an ohmic layer and a reflective layer through patterning.

In order to solve the above problem, the semiconductor light emitting device according to the exemplary embodiment can include a reflective contact layer 147. The reflective contact layer 147 can be disposed under the light emitting structure and can include a reflective layer 140 and an ohmic contact area 145. The reflective layer 140 can include AgAu, which is an alloy of Ag (silver) and Au (gold). In addition, the ohmic contact area 145 can be disposed on a lower surface of the light emitting structure 130. The ohmic contact area 145 can be plural. Also, the plurality of ohmic contact areas 145 can be distributed and arranged in an island shape on the lower surface of the first conductivity-type semiconductor layer 131, and the plurality of contact regions can form a predetermined layer, but is not limited thereto. The ohmic contact area 145 can include at least one of AuGe, Ge, GeNi, Ti, Pd, Nu, or IZO.

Further, the ohmic contact area 145 can be randomly distributed in an irregular size in the reflective layer 140. In addition, a lower surface of the ohmic contact area 145 can be closer to the first conductivity-type semiconductor layer 131 than a lower surface of the reflective layer 140. In addition, the lower surface of the first conductivity-type semiconductor layer 131 can include a region in contact with the reflective layer 140 and a region in contact with the ohmic contact area 145. The ohmic contact area 145 can occupy about 5% or more of an area of the lower surface of the first conductivity-type semiconductor layer 131. For example, the ohmic contact area 145 can occupy about 5% to about 20% of the area under the first conductivity-type semiconductor layer 131. In addition, preferably, the ohmic contact area 145 can occupy about 7% to about 18% of the area of the lower surface of the first conductivity-type semiconductor layer 131. In addition, preferably, the ohmic contact area 145 can occupy about 10% to about 16% of the area of the lower surface of the first conductivity-type semiconductor layer 131.

Because the ohmic contact area 145 is randomly arranged to come into contact with the first conductivity-type semiconductor layer 131 through internal diffusion, the electrical connection can be stably performed even if the contact area is minimized. Accordingly, there is a technical effect of further improving the reflectivity by securing a wide area of the reflective layer.

For example, the reflective contact layer 147 can be formed by depositing Ag (silver) and depositing Au (gold) on the AuGe layer, followed by heat treatment. The temperature of the heat treatment can be about 100° C or higher. During heat treatment, Ge can be inter-diffused and can be disposed on the lower surface of the first conductivity-type semiconductor layer 131 and can be used as the ohmic contact area 145. The ohmic contact area 145 can have an irregular size ranging from 0.01nm to several µm.

In addition, Ag and Au can form an AgAu alloy by heat treatment. Accordingly, the embodiment has a technical effect of lowering the difficulty of the process, not increasing the thickness of the chip, and sufficiently securing reflectivity, unlike the ODR layer or the DBR layer, which may have a complicated process and increase the thickness of the chip. In addition, according to the embodiment, the ohmic contact area 145 and the reflective layer 140 can be formed regardless of the size of the chip. For example, the embodiment can be applied even to an ultra-small semiconductor light emitting device having a size of 1µm unit. On the other hand, the composition of AgAu can be controlled according to the thickness of metal Ag and Au.

In addition, the reflectance of the reflective layer 140 in a specific wavelength region can vary according to the composition of AgAu. Accordingly, the embodiment has a technical effect of obtaining high reflectivity in each wavelength region of RGB color by controlling the thickness of Ag and Au. Ag can serve as a barrier protecting the ohmic contact area 145, and can serve as a reflective layer reflecting light of the semiconductor light emitting device upward through the AgAu alloy. Therefore, the embodiment has a technical effect of improving electrical reliability by protecting the ohmic contact area 145 from the reflective layer 140. And in the embodiment, since the reflective layer 140 is disposed in an area other than the ohmic contact area 145, there is a technical effect of improving light efficiency.

Also, for self-assembly of a semiconductor light emitting device into a panel substrate in an internally researched technology, the assembly is performed in a fluid. When the reflective layer of the semiconductor light emitting device is formed of a single metal, such as Ag, and the fluid dispersion proceeds, peel-off problem of the metal constituting the reflective layer can occur, and the peel-off metal material is dispersed in the fluid and interferes with self-assembly, thereby reducing the normal assembly rate.

In contrast, the embodiment uses an AgAu alloy rather than a single metal material such as Ag or Al, so that the reflective layer 140 is chemically stabilized even when self-assembly in the fluid proceeds, thereby solving the metal peel-off problem. Accordingly, there is a special technical effect of improving the assembly rate.

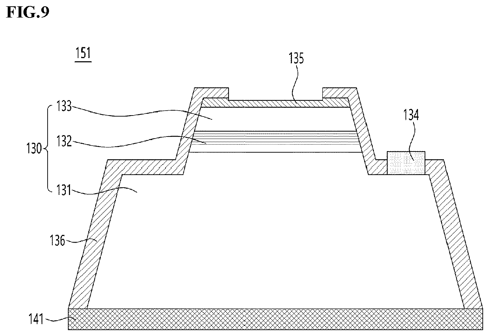

Next, FIG. 9 is a cross-sectional view of the pixel semiconductor light emitting device 151 according to the second embodiment. The second embodiment can adopt the technical features of the first embodiment. Referring to FIG. 9, the pixel semiconductor according to the second embodiment can have a horizontal structure. The second embodiment can include a light emitting structure 130, a first electrode 134, a second electrode 135, a reflective layer 141, and a passivation layer 136.

In more detail, the second electrode 135 can be disposed on the light emitting structure 130. The first electrode 134 can be disposed on the first conductivity-type semiconductor layer 131 of the light emitting structure 130. Also, the reflective layer 141 can be disposed under the light emitting structure 130. In this instance, the reflective layer 141 can include AgAu alloy. The light emitting structure 130 can receive an electrical signal through the first electrode 134 and the second electrode 135, and the reflective layer 141 can reflect the generated light upward.

When the reflective layer 141 is formed of AgAu alloy, it is not oxidized and peeled off during self-assembly in the fluid, so that there is a technical effect capable of preventing chip damage and preventing a reduction in assembly rate. In addition, the second embodiment can have a smoother surface than the reflective layer of a single metal during heat treatment, and thus has a technical effect of improving light efficiency. Also, the second embodiment has a technical effect of reducing the difficulty of the process because the reflective layer can be formed only through deposition and heat treatment without forming an ODR layer or DBR layer, which are complicated processes in a horizontal chip structure.

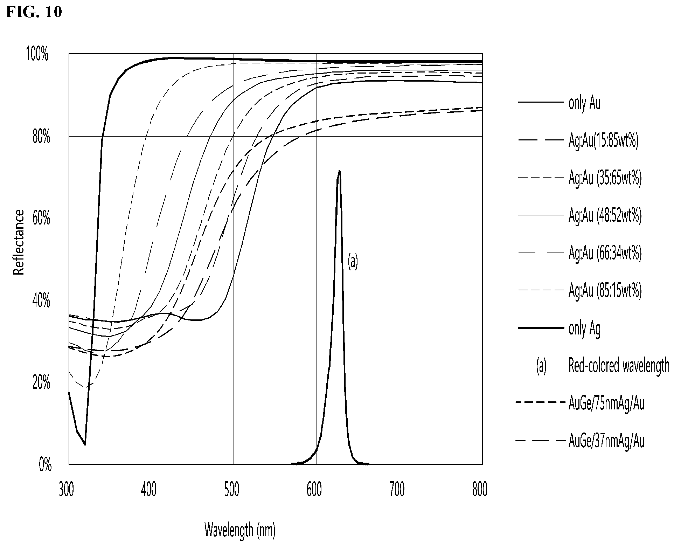

Next, FIG. 10 is a graph of reflectivity of a reflective layer applied to an embodiment. Referring to FIG. 10, at a wavelength (a) of about 620 nm corresponding to red color, Ag can have reflectivity of about 98%, and Au can have reflectivity of about 86%. When only a single metal, such as Ag or Au, is used as the reflective layer, roughness can be formed on the surface of the metal after heat treatment, so that upside reflection may not be smooth, and the metal can be oxidized.

In addition, when the reflective layer is formed of AuGe, in a semiconductor light emitting device emitting red color, during heat treatment for the GaAs contact of the N-type semiconductor layer, Au promotes out diffusion of Ga, and Ge and Ni are diffused in place of Ga to form GeNi contact. Accordingly, there is a problem in that the surface is not smooth and light can be absorbed by GeNi, reducing light efficiency. On the other hand, since the reflective layer of the embodiment is formed of an alloy of AgAu, the problem of a single metal reflective layer can be solved, and light efficiency can be improved without growing a DBR structure on the bottom or adding any texturing process during epitaxial growth.

In addition, AgAu alloys can have different wavelength regions in which reflectance is saturated depending on the composition ratio. Therefore, the embodiment has a special technical effect of securing reflectivity for each wavelength band by changing the composition ratio of the AgAu alloy according to the red, blue, and green color semiconductor light emitting devices. In addition, reflectivity can be improved as the composition of Ag increases in the AgAu alloy of the embodiment. The composition ratio of the AgAu alloy can be controlled through the deposition thickness of Ag and Au when forming the reflective layer. The composition ratio of the AgAu alloy can be controlled through the deposition thickness of Ag and Au when forming the reflective layer.

Accordingly, the embodiment has technical effects of improving light efficiency and forming a uniform reflective layer without increasing the thickness of the semiconductor light emitting device or increasing the process difficulty by forming the reflective layer using the AgAu alloy. The semiconductor light emitting device for a pixel according to the embodiment has a reflective layer provided under the chip, so that light efficiency can be improved. For example, since the reflective layer is formed to include an AgAu alloy, the reflective layer cannot be damaged in the self-assembly method, and the ohmic contact layer can be manufactured thinly to improve light efficiency.

In addition, the embodiment has a technical effect of improving the regular assembly rate in the self-assembly method. For example, as the embodiment includes a reflective layer including an AgAu alloy, the embodiment has a technical effect of improving the normal assembly rate because the metal material does not interfere with assembly because the metal is not oxidized or peeled off during self-assembly in a fluid. In addition, the embodiment has a technical effect of securing high reflectivity for each wavelength band of RGB color.

By controlling the composition of the AgAu alloy included in the reflective layer of the embodiment, it is possible to have high reflectivity with respect to each wavelength band of RGB colors. In addition, the embodiment can improve light efficiency without increasing the thickness of the semiconductor light emitting device or increasing the difficulty of the process.

For example, as the embodiment includes a reflective layer including an AgAu alloy, light efficiency of a semiconductor light emitting device can be improved with a thinner thickness and lower process difficulty than reflective layers such as DBR and ODR. In addition, in the embodiment, the ohmic contact area 145 is protected from the reflective layer 140, so that electrical reliability can be improved. The above description is merely an example of the technical idea of the present invention.

Various embodiments described herein may be implemented in a computer-readable medium using, for example, software, hardware, or some combination thereof. For example, the embodiments described herein may be implemented within one or more of Application Specific Integrated Circuits (ASICs), Digital Signal Processors (DSPs), Digital Signal Processing Devices (DSPDs), Programmable Logic Devices (PLDs), Field Programmable Gate Arrays (FPGAs), processors, controllers, micro-controllers, microprocessors, other electronic units designed to perform the functions described herein, or a selective combination thereof. In some cases, such embodiments are implemented by the controller. That is, the controller is a hardware-embedded processor executing the appropriate algorithms (e.g., flowcharts) for performing the described functions and thus has sufficient structure. Also, the embodiments such as procedures and functions may be implemented together with separate software modules each of which performs at least one of functions and operations. The software codes can be implemented with a software application written in any suitable programming language. Also, the software codes can be stored in the memory and executed by the controller, thus making the controller a type of special purpose controller specifically configured to carry out the described functions and algorithms. Thus, the components shown in the drawings have sufficient structure to implement the appropriate algorithms for performing the described functions.

The present invention encompasses various modifications to each of the examples and embodiments discussed herein. According to the invention, one or more features described above in one embodiment or example can be equally applied to another embodiment or example described above. The features of one or more embodiments or examples described above can be combined into each of the embodiments or examples described above. Any full or partial combination of one or more embodiment or examples of the invention is also part of the invention.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalence of such metes and bounds are therefore intended to be embraced by the appended claims.

## Claims

1. A semiconductor light emitting device, comprising:
a light emitting structure including a first conductivity-type semiconductor layer, an active layer disposed on the first conductivity-type semiconductor layer, and a second conductivity-type semiconductor layer disposed on the active layer; and
a reflective contact layer disposed below the light emitting structure,
wherein the reflective contact layer comprises:
a plurality of ohmic contact areas contacting the first conductivity-type semiconductor layer in which a first ohmic contact area has a different size than a second ohmic contact area included in the plurality of ohmic contact areas; and
a first reflective layer comprising an AgAu alloy and covering the plurality of ohmic contact areas.

2. The semiconductor light emitting device according to claim 1, wherein the plurality of ohmic contact areas contact a lower surface of the first conductivity-type semiconductor layer.

3. The semiconductor light emitting device according to any one of claim 1 or claim 2, wherein a lower surface of the plurality of ohmic contact areas is disposed closer to the first conductivity-type semiconductor layer than a lower surface of the first reflective layer.

4. The semiconductor light emitting device according to any one of claims 1 to 3, wherein the plurality of ohmic contact areas comprises at least one of AuGe, Ge, Ti, Pd, Ni, or IZO.

5. The semiconductor light emitting device according to any one of claims 1 to 4,
wherein the plurality the ohmic contact areas have an irregular size.

6. The semiconductor light emitting device according to any one of claims 1 to 5, wherein a lower surface of the first conductivity-type semiconductor layer includes:
a first region contacting the plurality of ohmic contact areas; and
a second region contacting the first reflective layer.

7. The semiconductor light emitting device according to claim 6, wherein the first region is 5% to 20% of a total area of the lower surface of the first conductivity-type semiconductor layer.

8. The semiconductor light emitting device according to claim 7, wherein the first region is 10% to 16% of the area of the lower surface of the first conductivity-type semiconductor layer.

9. The semiconductor light emitting device according to any one of claims 1 to 8, wherein the first reflective layer has a different reflectivity for each wavelength band of RGB color according to a composition of the AgAu alloy.

10. The semiconductor light emitting device according to any one of claims 1 to 9, further comprising:
a first electrode for transmitting an electrical signal from a wiring for driving the semiconductor light emitting device.

11. The semiconductor light emitting device according to any one of claims 1 to 10, further comprising:
a passivation layer surrounding the light emitting structure.

12. The semiconductor light emitting device according to any one of claims 1 to 11, wherein the first reflective layer is disposed between each of the plurality of ohmic contact areas.

13. The semiconductor light emitting device according to any one of claims 1 to 12, wherein a thickness of the first reflective layer is greater than a thickness of the plurality of ohmic contact areas.

14. A method of manufacturing a semiconductor light emitting device for a pixel, the method comprising:
forming a light emitting structure including a first conductivity type semiconductor layer, an active layer, and a second conductivity type semiconductor layer;
forming a first metal layer including AuGe on the light emitting structure;
forming a second metal layer including Ag on the first metal layer;
forming a third metal layer including Au on the second metal layer; and
heat treating the first metal layer, the second metal layer, and the third metal layer, including diffusing Ge of the first metal layer inward to form a plurality of ohmic contact regions contacting the first conductivity type semiconductor layer,
wherein Ag of the second metal layer and Au of the first metal layer and the third metal layer form an AgAu alloy to form a first reflective layer.

15. The method according to claim 14, wherein the plurality of ohmic contact regions are randomly distributed, and contact between 5% and 20% of a total area of the first conductivity type semiconductor layer.
